# EUROPEAN PATENT SPECIFICATION

(11) **EP 1 927 271 B1**
(45) Date of publication and mention of the grant of the patent: **09.11.2011**
(21) Application number: 06795805.8
(22) Date of filing: 29.08.2006
(51) Int. Cl.: H05B 37/02

(54) **METHOD TO DETERMINE A RELATIVE POSITION OF DEVICES IN A NETWORK, AND NETWORK OF DEVICES FOR CARRYING OUT THE METHOD**
VERFAHREN ZUR BESTIMMUNG EINER RELATIVEN POSITION VON VORRICHTUNGEN IN EINEM NETZWERK UND NETZWERK VON VORRICHTUNGEN ZUR AUSFÜHRUNG DES VERFAHRENS
PROCEDE PERMETTANT DE DETERMINER LA POSITION RELATIVE DE DISPOSITIFS DANS UN RESEAU, ET RESEAU DE DISPOSITIFS PERMETTANT DE METTRE EN OEUVRE LEDIT PROCEDE

(30) Priority: 12.09.2005 EP 05108323
(43) Date of publication of application: 04.06.2008
(73) Proprietor: Koninklijke Philips Electronics N.V., 5621 BA Eindhoven (NL)
(72) Inventor: STEVENS, Hendrik, NL-5656 AA Eindhoven (NL)
(74) Representative: Bekkers, Joost J.J
(86) International application number: PCT/IB2006/052989
(87) International publication number: WO 2007/031891

(56) References cited:
- WO-A-95/01030
- US-A1- 2002 126 020
- US-A1- 2003 222 603

## Description

### FIELD OF THE INVENTION

The invention relates to a method to determine a relative position of devices in a network, and to a network of devices for carrying out the method.

### BACKGROUND OF THE INVENTION

In more or less complex systems with several controllable devices, such as larger lighting systems in buildings, along roads etc., it is often desirable to bind a device, e.g. a lamp with a switch, into that system. This allows for example a remote control of the devices. Nowadays, devices may be used that have their own unique ID. Still it is necessary to know "where" those devices are located in the system for an operator or control unit to be able to control the right device.
US Application No. 2003/0222603 and PCT publication WO95/01030 disclose a system and method for correlating between the location of a component and its ID. In one embodiment, each component is operated separately, and an operator records the physical coordinates in each case. This is very time consuming, and needs at least one person, and possibly more in case the devices may not be checked from the position of the operator, such as lighting systems in large building etc. Sometimes it is also difficult to activate the device, such as a street lamp on a high pole.

### SUMMARY OF THE INVENTION

It is an object of the invention to provide a method, that is able to provide information on the actual physical position of several devices in a network, with less amount of work.
It is also an object of the invention to provide a system for carrying out the method.
Thereto, the invention provides a method of the kind mentioned in the preamble, and comprising the following steps:
- providing a network with a cable, and a plurality of addressable devices and a control unit connected thereby,
- selecting one of the plurality of devices, the other devices being remaining devices,
- synchronizing the devices,
- providing a detection signal on the network, by means of the selected device, which detection signal may be detected by the remaining devices,
   wherein the detection signal has an amplitude that increases as a function of time,
- determining a detection time for each remaining device, at which detection time said remaining device is able to detect the detection signal,
- collecting the respective detection times of the remaining devices in the control unit, and
- evaluating the detection times in order to determine the relative position of the devices.
The method according to the invention offers the possibility that the position of devices is determined at least with respect to each other, based on the time it takes for a signal sent by one of the devices in the network to be measured by the other devices. In the method according to the invention, one of the devices, even including the control unit itself, is selected for sending a detection signal into the network. This detection signal will propagate along the cables of the network and will be attenuated, because those cables will show losses. This means that devices which are physically further away from the sending device will receive a weaker signal, and in general will only later in time be able to detect the signal. By increasing the amplitude of the signal, more and more devices that are further and further away will be able to detect the signal. In other words, the physical distance to the sending device may be determined by the time it takes for the device to be able to detect the signal of the sending device for the first time. By collecting these times, the detection times, much is learned about the physical order of the devices in the network, relative to the sending device. If the network is e.g. a linear network, the relative order of the devices may thus be determined, and thus also the absolute order and the physical position of the devices. This information may directly be used by a system or an operator. Much work is saved, and the method may even be automated, as will be discussed below.
The invention also provides a network of devices, comprising a cable (10), and a plurality of addressable devices (A-I; A-J) and a control unit (12) connected thereby, wherein the devices being provided with an internal clock which are synchronized to be able to measure time, and a selected device of the network of devices (A-I; A-J) is able to provide a detection signal on the network, wherein the detection signal has an amplitude that increases as a function of time and each remaining device is able to determine a detection time, at which detection time said remaining device is able to detect the detection signal and the control unit is able to collect the respective detection times of the remaining devices, and to evaluate the detection times in order to determine the relative position of the devices (A-I; A-J).

Herein, "addressable" means that the device may respond to message across the network that carry its specific ID. The network according to the invention offers the possibility that the physical order and position of the devices may be determined without an operator operating the devices separately. This saves a lot of work when installing the devices, e.g. when "binding" them.

Various embodiments of the invention are possible and form the subject matter of dependent claims, which will be discussed below.
In particular, the detection time for a remaining device is determined as a time between synchronization and a first time that a signal above a predetermined level is determined by said device. Synchronization may e.g. take place through any known protocol, such as a PowerLon protocol, or by simply supplying a signal on the network that may be detected by every device and may be used to (re)set an internal clock. Such a signal could be a short and relatively strong peak signal of say 100 mV. Preferably, this synchronization signal has other characteristics than the detection signal used, for example a different frequency. This prevents confusion or colliding signals. Note that the devices should comprise an internal clock, in order to be able to measure time. Furthermore note that when the selected device sends a synchronization signal through the network, such signal will also be delayed by a certain period of time per unit length of cable, just as would the detection signal. If this delay per length is substantially the same for the synchronization signal and the detection signal, the time measurement may be very precise. But even if this delay is somewhat different, the method and system according to the invention are still able to determine a relative time delay, and thus a relative distance, albeit somewhat less precise.
The devices of the network should have an internal clock, such as may be present in various ICs. Furthermore, the devices should be able to detect the signals and communicate (synchronization, detection, interrogation when collection data), and send detection signals across the network, such as the detection time information, and at least for the selected device(s) also detection signals. All such details are well known in the art, and need not be explained further here.

In a particular embodiment, the step of evaluating the detection times comprises ordering the detection times in one of an increasing order and a decreasing order. This is a simple and efficient way of determining a (physical) order of the devices in the network. When a device is further away from the selected device that sent the detection signal, the time delay will be greater, and vice versa. Thus, ordering the devices according to the detection time allows also establishing a physical order.
In a special embodiment, the method further includes the step of providing to the control unit a wiring map of the network. Such a wiring map is almost always available for the network, and provides information on where devices are located, without having knowledge of the location of the individual devices. The method according to the invention will then be able to provide this latter information. In other words, the method allows to fill in the individual IDs of the devices across the wiring map, in order to be able to control those individual devices. Note that in the case of a single linear network, such as lighting along a single street, such wiring map would not provide much additional information. However, in cases such as a wiring map of the lighting in a many-storey building, such combination may prove more efficient. Note that such a wiring map may be entered into the control unit as some logical set of data.
In a particular embodiment, the method further comprises selecting one of the remaining devices, preferably with a highest detection time, and repeating the steps of synchronizing, providing a detection signal, determining and collecting the detection times, and re-evaluating the relative position of the devices. This may be useful in for example the following situations. When the device that is to send the detection signal is selected randomly, which is usually the case just because no further information is available, then it is likely that there are devices present in at least two directions. In such a case it is difficult to determine the physical order of all devices with certainty, since any time delay may be caused in any direction of the selected device. Further information may be obtained by subsequently selecting one of the remaining devices, i.e. on of the other devices, as the new selected device that is to send the detection signals, and to repeat the steps for determining and collecting the detection times for the other devices. In this way, additional order information is obtained, that may be combined with the first information in order to determine the true physical order of the devices in the network. A useful criterion for selecting another device may be the highest detection time, since the device with the highest detection time will usually be the most remote device, and thus at the end of a line. Selecting such device leaves only one direction for the other devices.
In certain cases, it may occur that there are complex more connections in the network, such as parallel or branched connections etc., for all of which the expression "parallel" will be used in this application for brevity's sake. These more complex connections may cause certain devices to present the same, or at least similar, detection times, without being physically on the same position. In such case it could be helpful to select one of the parallel devices as the device to send the detection signal. This decreases the number of devices that is parallel in the new detection by at least one. Note that in the case of three or more strictly symmetrical parallel devices, this would not suffice, and e.g. a manual detection is still required. However, this only is a problem if also the supply cables of those parallel devices are all equally long, thus causing the same detection times. And still, the present method would still provide good time savings, at least for those devices which are not strictly symmetrically parallel.
In a special embodiment, the network comprises a cable that has substantially constant properties as to delay time and attenuation per unit length. This allows rather accurate measurements of the detection time, and would even allow measurements of absolute distance. However, it is not necessary for the cables to have such constant properties along their length, but they could vary somewhat along their length. This would make the measurements somewhat less accurate, but a longer detection time still means a longer distance, so the relative physical order may still be determined. Note that in principle the same type of cable will be used in all of the network, and thus the properties will be the same or very similar across the network. However, it is possible for the properties to be locally different, such as due to electrical leaks (bad insulation etc.) or other influences. Note that such different properties could be represented as a virtual extra cable length or missing cable length.
In particular, the detection signal comprises a signal having a frequency of between 10 kHz and 1 MHz, preferably between about 95 kHz and 148.5 kHz. More generally, the detection signal used should show a reasonable attenuation per unit length and be allowed by the network manager. Note that the unit length could depend on the dimensions of the network: a very large network such as lighting along a motorway and a small network, such as the lighting in a private house may require a different detection time resolution, and thus a different unit length. Furthermore, in many cases a reasonable attenuation is obtained by using the so-called skin effect in electrical cables. This causes electrical current to be conducted primarily in a thin surface layer, which thus increases the losses (attenuation). The skin effect increases with frequency. E.g. a DC signal is carried by all of the conductor, whatever its cross-section, and a many MHz signal is carried (if at all in the conductor) only in an extremely thin surface layer. The indicated ranges are useful in that they provide a reasonable loss, and thus a resolution of distance. Other frequencies are not excluded, however, for example in case attenuation is due to other reasons, such as inherent much higher resistive losses in the cable. Note that it may be advantageous to use different frequencies for the detection signal and communication between the devices and the control unit.

It may offer advantages to use the power line network as the network. This means that the signals that are used in the method are carried by the power line cables. In many countries such communication by signals across the power lines is subject to regulations. For example, in Europe, power line signaling must be confined to the 9 kHz - 148.5 kHz frequency range. This spectrum is further divided in to "bands" and allocated for specific applications, as follows:
- A-band: 9-95 kHz for electricity suppliers
- B-band: 95-125 kHz for consumer use without protocols
- C-band: 125-140 kHz for consumer use with the CENELEC protocol
- D-band: 140-148.5 kHz for consumer use without protocols
- Above 148.5 kHz: power line communications prohibited.
In other countries other bands may apply, in which case the frequency of the detection signals and/or other signals might be adjusted.
The manner in which the strength of the detection signal is varied is not strictly limited. However, in a particular embodiment, the amplitude of the detection signal is increased substantially linearly in time. This gives a very elegant and simple correspondence between signal strength and time. For example, the devices may have a detection limit of say *x* mV, and the amplitude of the detection signal starts at some lower value, or e.g. simply at 0 mV. Then, by increasing the amplitude, at some point in time the nearest remaining device will for the first time detect the detection signal, because the local signal strength is higher than the detection limit. The detection time is recorded. Then, while the detection signal strength still increases, more and more devices will detect the signal, until all devices have detected the detection signal. Then, all detection times can be read and collected in and by the control unit. Note that the detection limit could be set equal to a noise level in the cable. However, it is also possible to set this limit to a somewhat higher value, to rule out effects by this random noise.
In an alternative embodiment, the amplitude of the detection signal is increased substantially logarithmically in time. In other words, the amplitude is increased, but at an ever decreasing rate, keeping into account the effect that the detection signal will often show a substantially exponential decay along the cables of the network. By careful selection of the logarithmic parameters it is possible to obtain a method in which the correlation between time and distance is substantially linear.
In another alternative embodiment, the amplitude of the detection signal is increased step-like, preferably with a time of constant amplitude of between about 1 ms and 5 s, preferably between about 5 ms and 0.1 s. Although a step-like increase may affect the absolute resolution of the detection, this embodiment has an advantage in that it makes the measurement more reliable. During the plateau-level of a step, the amplitude is well defined during a certain period of time. This means that temporary or varying effects, such as noise or voltage peaks etc., may be averaged out. This may e.g. be achieved by repeating the detection measurement during that plateau time, or by detecting during said plateau and only counting a measurement if the detection may be done reliably during substantially all of that plateau, etc.
By selecting the step-size appropriately, any required resolution may still be obtained. The step-size may for example be chosen to be linear in time, i.e. always equal increases, or logarithmical in time, et cetera. In a particular embodiment, the detection signal is increased in steps of between about 0.5 mV and 10 mV, preferably of between 1 mV and 5 mV. Such step-sizes offer a sufficient resolution in most cases, while the total number of steps is sufficiently limited. Especially in combination with the above mentioned time scales, the total measurements may be carried out swiftly and reliably. Still, other measurement times may also be selected, for example shorter time periods than 1 ms, especially in case there is very little noise, or very quick measurement devices.
As already mentioned above, the invention also provides a network of devices, comprising a plurality of addressable devices and a control unit, wherein the network of devices is constructed and arranged for carrying out the method of the invention.
In particular, at least two devices, and preferably all devices, are able to supply and detect a detection signal and to determine an elapsed time. Although in principle all devices of which the order is to be determined must be able to provide a signal in that the detection times must be read by the control unit or the like, it is advantageous when more than one device may serve as a source for the detection signal. Then, in case there is ambiguity about the position of two or more devices, one or more of the other devices that are able to supply a detection signal may be used to carry out the method of the invention, and thus to provide additional or even sufficient information to determine the relative order of all devices. Note that it is not necessary for all devices to be able to supply such detection signal. Any number that limits the amount of work to be done by an operator is advantageous. Note furthermore that the same considerations as to the detection signal also hold for the synchronization signal, which is also to be supplied by the selected device or devices.

### BRIEF DESCRIPTION OF THE DRAWINGS

These and other aspects of the invention are apparent from and will be elucidated with reference to the embodiments described hereinafter.
In the drawings:
Fig. 1 shows diagrammatically a network for the method according to the invention;
Figs. 2a en 2b show examples of detection voltage vs. time;
Fig. 3 diagrammatically shows an alternative network.

### DETAILED DESCRIPTION OF THE PREFERRED EMBODIMENTS

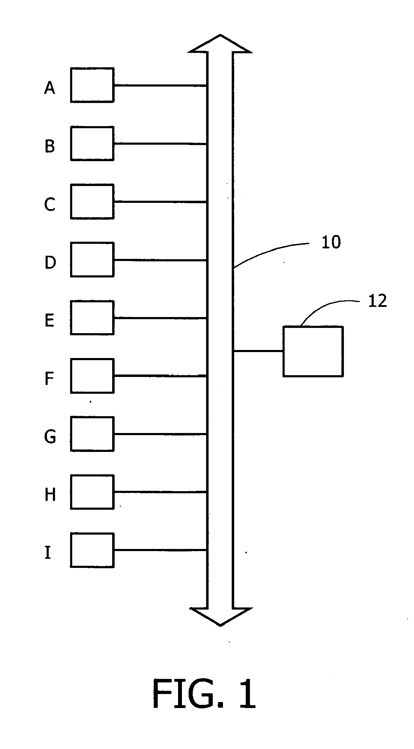

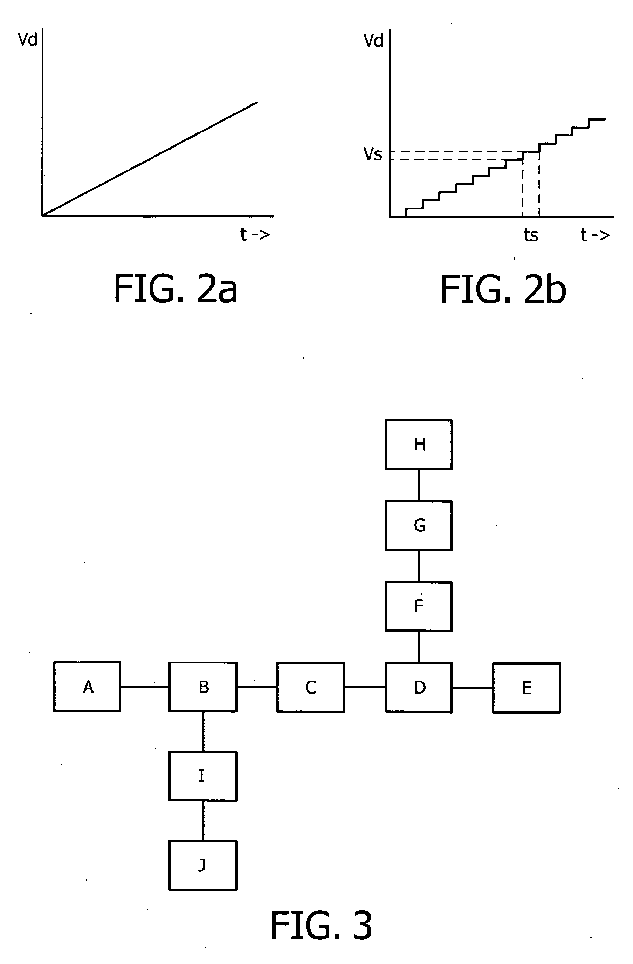

Fig. 1 shows diagrammatically a network for the method according to the invention. Herein, 10 is a diagrammatic power cable, 12 is a control unit, while A through I are nine devices which are connected via the power cable 10.
Such a network could e.g. be a lighting network, a video camera circuit, an alarm network and so on. The arrow heads at the ends of the power cable 10 indicate that in each direction more, or less, devices may be connected. Before carrying out the method, the devices have a unique ID, but it is not yet known where those devices are located.
The method of the invention could be worked as follows. A device is selected, e.g. randomly. Suppose a device is selected which will (later) turn out to be the device denoted F in the Figure 1. In principle, any other device could also be the selected device.
This will be discussed further with reference to Fig. 3
As a first step, a synchronization of all devices A-I is carried out. Thereto, the selected device F may emit a pulse or other suitable signal across the network. Such synchronization could also be carried out by the control unit, according to known synchronization protocols. Next, the selected device F will start supplying a detection signal on the network, for example a voltage sweep, or a step-like increased signal. The signal may have a frequency which is allowed, in case the network cable 10 is connected to mains, and which is useful in that it allows the signal to exhibit a sufficient attenuation along the length of the cable 10. In this case, a frequency of 120 kHz is selected, although in Europe, any frequency in the band 95-148.5 kHz could be selected. Furthermore, when the cable 10 is not connected to the mains, any desired and appropriate frequency could be used.
Figs. 2a and 2b show examples of the amplitude of the detection signal Vd versus time t. Fig. 2a is a simple linear sweep. Fig. 2b shows a step-like increase, with steps of a magnitude Vs, and a step time of ts, during which the amplitude is substantially a constant and a detection may be carried out reliably. Vd and ts may be selected according to the desired accuracy, but e.g. a step size between 1 and 5 mV, and between 10 and 200 ms are good and useful values, although other values may be used when circumstance (e.g. lots of noise) would require so.
Now, in the network of Fig. 1, there are two tracks of devices, viz. E to A and G to I. When F starts sending the detection signal, in the first track it will be device E that will first detect the signal, and E will thus have the smallest value of the detection time td, let's say 1T. The next device to detect the detection signal will be D, with a td of say 2T, et cetera. A similar result will be obtained for the devices in the second track. In this example, it is assumed that the distance between neighboring devices is a constant, and the detection signal voltage is increased in such a way that the detection time depends substantially linearly on the actual distance along the network cable, for example with a logarithmic increase.
When the selected device F has finished its job, the detection time of each remaining device A-E and G-I is read and collected by the control unit 12, such as a computer or any other suitable circuitry. In this way, one obtains a table of detection times, e.g. Table 1

**Table 1**

| device path | detection time |
|---|---|
| FA | 5T |
| FB | 4T |
| FC | 3T |
| FD | 2T |
| FE | 1T |
| FG | 1T |
| FH | 2T |
| FI | 3T |

Without further knowledge of the wiring of the network, it is not obvious what the order of the devices in the network actually is. This is plain when looking at e.g. devices E and G, which show the same detection time. However, it is clear that A must be furthest away.

Hence, a next step could be to select A as the selected device, or "sender", and repeat the method with this new selected device A. According to this method, one again obtains a table with results, i.e. Table 2 below.

**Table 2**

| device path | detection time |
|---|---|
| AB | 1T |
| AC | 2T |
| AD | 3T |
| AE | 4T |
| AF | 5T |
| AG | 6T |
| AH | 7T |
| AI | 8T |

From this table it is clear that the devices are located in an order that corresponds to the alphabetical order. This simple example shows that the method is capable of providing information about the physical order, at least relative to each other, of devices in a network.
In practice, the network will often be more complex. As an example, Fig. 3 is shown, which has 10 devices, a row of 5 (A through E) with two branches (B-I-J and D-F-G-H). Again, for simplicity, it is assumed that the propagation time or delay time between neighboring devices is 1 T. When the selected device is E.G. device A, it is not possible to tell the relative order of all devices, since e.g. C and I will show the same detection times in pairs.
In such more complex networks, it may prove advantageous to use many, or all of the devices as a selected device. Elaborating this example for Fig. 3 we obtain: We start with device A and the last device is J. When collecting the time information from every send cycle, following matrix will be derived.

**Table 3 Detection times for various selected devices**

| Sender | Detected times at devices (xT) | | | | | | | | | |
|---|---|---|---|---|---|---|---|---|---|---|
| | A | B | C | D | E | F | G | H | I | J |
| A | 0 | 1 | 2 | 3 | 4 | 4 | 5 | 6 | 2 | 3 |
| B | 1 | 0 | 1 | 2 | 3 | 3 | 4 | 5 | 1 | 2 |
| C | 2 | 1 | 0 | 1 | 2 | 2 | 3 | 4 | 2 | 3 |
| D | 3 | 2 | 1 | 0 | 1 | 1 | 2 | 3 | 3 | 4 |
| E | 4 | 3 | 2 | 1 | 0 | 2 | 3 | 4 | 4 | 5 |
| F | 4 | 3 | 2 | 1 | 2 | 0 | 1 | 2 | 4 | 5 |
| G | 5 | 4 | 3 | 2 | 3 | 1 | 0 | 1 | 5 | 6 |
| H | 6 | 5 | 4 | 3 | 4 | 2 | 1 | 0 | 6 | 7 |
| I | 2 | 1 | 2 | 3 | 4 | 4 | 5 | 6 | 0 | 1 |
| J | 3 | 2 | 3 | 4 | 5 | 5 | 6 | 7 | 1 | 0 |

In this Table from every sender, we can see at which time a device detected the detection signal. For example: with device A being the selected device, remaining device H detected the detection signal at time 6T. The detection signal will spread over the network, and causes lower signal levels in different paths. For the present localization method, in principle the neighbors are sufficient, because they always will receive the detection signal first. So the next step will be to create a matrix with only the direct neighbors (1T) of a sender.

**Table 4 Direct neighbors**

| Sender | Detected times at devices (xT) | | | | | | | | | |
|---|---|---|---|---|---|---|---|---|---|---|
| | A | B | C | D | E | F | G | H | I | J |
| A | 0 | 1 | | | | | | | | |
| B | 1 | 0 | 1 | | | | | | 1 | |
| C | | 1 | 0 | 1 | | | | | | |
| D | | | 1 | 0 | 1 | 1 | | | | |
| E | | | | 1 | 0 | | | | | |
| F | | | | 1 | | 0 | 1 | | | |
| G | | | | | | 1 | 0 | 1 | | |
| H | | | | | | | 1 | 0 | | |
| I | | 1 | | | | | | | 0 | 1 |
| J | | | | | | | | | 1 | 0 |

Now it is clear which devices are the direct neighbors. Now, by connecting Let's fill in the matrix in a different way, and filling in the name of the neighbors.

**Table 5. Direct neighbors, expressed differently**

| Sender | Direct Neighborhood table | | | | | | | | | |
|---|---|---|---|---|---|---|---|---|---|---|
| | A | B | C | D | E | F | G | H | I | J |
| A | | B | | | | | | | | |
| B | A | | C | | | | | | I | |
| C | | B | | D | | | | | | |
| D | | | C | | E | F | | | | |
| E | | | | D | | | | | | |
| F | | | | D | | | G | | | |
| G | | | | | | F | | H | | |
| H | | | | | | | G | | | |
| I | | B | | | | | | | | J |
| J | | | | | | | | | I | |

The matrix indicates that there is a path from Sender A to B, but also from Sender B to A. That is obvious, but only one path is needed. In fact when we start from above (at A), then the B to A path is not needed anymore, and can be removed from the table. This will lead to following table:

**Table 6, Direct neighbors, one-way only**

| Sender | Direct Neighborhood table | | | | | | | | | |
|---|---|---|---|---|---|---|---|---|---|---|
| | A | B | C | D | E | F | G | H | I | |
| A | | B | | | | | | | | |
| B | | | C | | | | | | I | |
| C | | | | D | | | | | | |
| D | | | | | E | F | | | | |
| E | | | | | | | | | | |
| F | | | | | | | G | | | |
| G | | | | | | | | H | | |
| H | | | | | | | | | | |
| I | | | | | | | | | | J |
| J | | | | | | | | | | |

Table 6 shows the routes when starting from A. Note: It could be starting from any Sender, not necessarily A. However, since it is easily established that A must be the end of a branch, A is a good candidate to start from, just as would have been E, H or J. Now it is possible to form routes, in the following way: starting at A, the only path (neighbor) is to device B. Device B has two direct neighbors, i.e. two branches C and I. To start with I, this device has one neighbor J, which in turn has no further neighbors, so this path ends here. Continuing with C, this device has one new neighbor D, etc. So following routes are found:
1) A-B-C-D-E
2) D-F-G-H
3) B-I-J
These routes can be easily mapped on the installation diagram, and assigning the location information into the diagram enables to bind all devices without manually having to operate each device.

It is possible to optimizing the method, since it is not always necessary for each device to act as a sender. One can already start calculating the routes after one or two detection cycles, and then check whether all the devices are located, i.e. connected in routes, or not. Devices that are not yet connected in a route should start with sending a detection signal to the others. The next step could be to again calculate the routes and check whether another cycle is needed.

## Claims

1. A method to determine a relative position of devices in a network, the method comprising the following steps:
- providing a network with a cable (10), and a plurality of addressable devices (A-I; A-J) and a control unit (12) connected thereby,
- selecting one of the plurality of devices (A-I; A-J), the other devices being remaining devices,
- synchronizing the devices (A-I; A-J),
- providing a detection signal on the network, by means of the selected device, which detection signal may be detected by the remaining devices,
wherein the detection signal has an amplitude that increases as a function of time,
- determining a detection time for each remaining device, at which detection time said remaining device is able to detect the detection signal,
- collecting the respective detection times of the remaining devices in the control unit (12), and
- evaluating the detection times in order to determine the relative position of the devices (A-I; A-J).

2. The method of claim 1, wherein the detection time for a remaining device is determined as a time between synchronization and a first time that a signal above a predetermined level is determined by said device.

3. The method of any preceding claim, wherein the step of evaluating the detection times comprises ordering the detection times in one of an increasing order and a decreasing order.

4. The method according to any preceding claim, further including the step of providing to the control unit (12) a wiring map of the network.

5. The method of any preceding claim, further comprising selecting one of the remaining devices, preferably with a highest detection time, and repeating the steps of synchronizing, providing a detection signal, determining and collecting the detection times, and re-evaluating the relative position of the devices (A-I; A-J).

6. The method of any preceding claim, wherein the network comprises a cable (10) that has substantially constant properties as to delay time and attenuation per unit length.

7. The method according to any preceding claim, wherein the detection signal comprises a signal having a frequency of between 10 kHz and 1 Mhz, preferably between about 95 kHz and 148.5 kHz.

8. The method according to any preceding claim, wherein the amplitude of the detection signal is increased substantially linearly in time.

9. The method according to any of the claims 1-8, wherein the amplitude of the detection signal is increased step-like, preferably with a time of constant amplitude of between about 1 ms and 5 s, preferably between about 5 ms and 0.1 s.

10. The method of claim 9, wherein the detection signal is increased in steps of between about 0.5 mV and 10 mV, preferably of between 1 mV and 5mV.

11. A network of devices, comprising a cable (10), and a plurality of addressable devices (A-I; A-J) and a control unit (12) connected thereby, the devices being provided with an internal clock which are synchronized to be able to measure time, and a selected device of the network of devices (A-I; A-J) is able to provide a detection signal on the network, wherein the detection signal has an amplitude that increases as a function of time and each remaining device is able to determine a detection time, at which detection time said remaining device is able to detect the detection signal and the control unit is able to collect the respective detection times of the remaining devices, and to evaluate the detection times in order to determine the relative position of the devices (A-I; A-J).

12. The network of claim 11, wherein at least two devices (A-I; A-J), and preferably all devices, are able to supply and detect a detection signal and to determine an elapsed time.

## Patentansprüche

1. Verfahren zum Ermitteln einer relativen Position von Einrichtungen in einem Netzwerk, wobei das Verfahren die folgenden Schritte umfasst, wonach:
- ein Netzwerk mit einer Leitung (10) und mehreren adressierbaren Einrichtungen (A-I; A-J) sowie einer damit verbundenen Steuereinheit (12) versehen wird,
- eine der mehreren Einrichtungen (A-I; A-J) ausgewählt wird, wobei die anderen Einrichtungen verbleibende Einrichtungen sind,
- die Einrichtungen (A-I; A-J) synchronisiert werden,
- mit Hilfe der ausgewählten Einrichtung ein Detektionssignal auf dem Netzwerk vorgesehen wird, wobei das Detektionssignal von den verbleibenden Einrichtungen detektiert werden kann,
wobei das Detektionssignal eine Amplitude aufweist, die als eine Zeitfunktion ansteigt,
- für jede verbleibende Einrichtung eine Detektionszeit ermittelt wird, zu der die verbleibende Einrichtung das Detektionssignal detektieren kann,
- die jeweiligen Detektionszeiten der verbleibenden Einrichtungen in der Steuereinheit (12) erfasst werden, und
- die Detektionszeiten ausgewertet werden, um die relative Position der Einrichtungen (A-I; A-J) zu ermitteln.

2. Verfahren nach Anspruch 1, wobei die Detektionszeit für eine verbleibende Einrichtung als ein Zeitpunkt zwischen Synchronisation und einem ersten Zeitpunkt, zu dem ein Signal über einem vorgegebenen Level von der Einrichtung ermittelt wird, festgelegt wird.

3. Verfahren nach einem der vorangegangenen Ansprüche, wobei der Schritt des Auswertens der Detektionszeiten das Ordnen der Detektionszeiten in zunehmender oder abnehmender Reihenfolge umfasst.

4. Verfahren nach einem der vorangegangenen Ansprüche, wonach weiterhin ein Verdrahtungsplan des Netzwerks für die Steuereinheit (12) bereitgestellt wird.

5. Verfahren nach einem der vorangegangenen Ansprüche, wonach weiterhin eine der verbleibenden Einrichtungen, vorzugsweise mit einer höchsten Detektionszeit, ausgewählt wird und die Schritte des Synchronisierens, des Bereitstellens eines Detektionssignals, des Ermittelns und Erfassens der Detektionszeiten sowie des erneuten Auswertens der relativen Position der Einrichtungen (A-I; A-J) wiederholt werden.

6. Verfahren nach einem der vorangegangenen Ansprüche, wobei das Netzwerk eine Leitung (10) umfasst, die im Wesentlichen konstante Eigenschaften im Hinblick auf Verzögerungszeit sowie Dämpfung pro Längeneinheit aufweist.

7. Verfahren nach einem der vorangegangenen Ansprüche, wobei das Detektionssignal ein Signal mit einer Frequenz zwischen 10 kHz und 1 MHz, vorzugsweise zwischen etwa 95 kHz und 148,5 kHz, umfasst.

8. Verfahren nach einem der vorangegangenen Ansprüche, wobei die Amplitude des Detektionssignals im Wesentlichen zeitlich linear erhöht wird.

9. Verfahren nach einem der Ansprüche 1-8, wobei die Amplitude des Detektionssignals schrittweise, vorzugsweise mit einem Zeitraum bei gleichbleibender Amplitude zwischen etwa 1 ms und 5 s, vorzugsweise zwischen etwa 5 ms und 0,1 s, erhöht wird.

10. Verfahren nach Anspruch 9, wobei das Detektionssignal in Schritten zwischen etwa 0,5 mV und 10 mV, vorzugsweise zwischen 1 mV und 5 mV, erhöht wird.

11. Netzwerk von Einrichtungen, mit einer Leitung (10) und mehreren adressierbaren Einrichtungen (A-I; A-J) sowie einer damit verbundenen Steuereinheit (12), wobei die Einrichtungen jeweils mit einem internen Zeitgeber versehen sind, die so synchronisiert werden, dass sie imstande sind, Zeit zu messen, und wobei eine ausgewählte Einrichtung des Netzwerks von Einrichtungen (A-I; A-J) imstande ist, ein Detektionssignal auf dem Netzwerk vorzusehen, wobei das Detektionssignal eine Amplitude aufweist, die als eine Zeitfunktion ansteigt und jede verbleibende Einrichtung imstande ist, eine Detektionszeit zu ermitteln, zu der die verbleibende Einrichtung das Detektionssignal detektieren kann, und wobei die Steuereinheit imstande ist, die jeweiligen Detektionszeiten der verbleibenden Einrichtungen zu erfassen und die Detektionszeiten auszuwerten, um die relative Position der Einrichtungen (A-I; A-J) zu ermitteln.

12. Netzwerk nach Anspruch 11, wobei mindestens zwei Einrichtungen (A-I; A-J), vorzugsweise alle Einrichtungen, imstande sind, ein Detektionssignal abzugeben und zu detektieren und eine abgelaufene Zeit zu ermitteln.

## Revendications

1. Procédé pour déterminer une position relative de dispositifs dans un réseau, le procédé comprenant les étapes suivantes :
- fourniture d'un réseau avec un câble (10), et une pluralité de dispositifs adressables (A-I ; A-J) et une unité de commande (12) raccordés ainsi,
- la sélection de l'un de la pluralité de dispositifs (A-I ; A-J), les autres dispositifs étant les dispositifs restants,
- la synchronisation des dispositifs (A-I ; A-J),
- la fourniture d'un signal de détection sur le réseau, au moyen du dispositif sélectionné, ledit signal de détection pouvant être détecté par les dispositifs restants,
dans lequel le signal de détection a une amplitude qui augmente en fonction du temps,
- la détermination d'un moment de détection pour chaque dispositif restant, moment de détection auquel ledit dispositif restant est capable de détecter le signal de détection,
- le recueil des moments de détection respectifs des dispositifs restants dans l'unité de commande (12), et
- l'évaluation des moments de détection afin de déterminer la position relative des dispositifs (A-I ; A-J).

2. Procédé selon la revendication 1, dans lequel le moment de détection pour un dispositif restant est déterminé comme un moment entre la synchronisation et un premier moment auquel un signal supérieur à un niveau prédéterminé est déterminé par ledit dispositif.

3. Procédé selon l'une quelconque des revendications précédentes, dans lequel l'étape de l'évaluation des moments de détection comprend l'ordonnancement des moments de détection dans l'un d'un ordre croissant et d'un ordre décroissant.

4. Procédé selon l'une quelconque des revendications précédentes, comprenant également l'étape de fourniture à l'unité de commande (12) d'une carte de câblage du réseau.

5. Procédé selon l'une quelconque des revendications précédentes, comprenant également la sélection de l'un des dispositifs restants, de préférence avec un moment de détection le plus élevé, et la répétition des étapes de synchronisation, fourniture d'un signal de détection, détermination et recueil des moments de détection, et réévaluation de la position relative des dispositifs (A-I ; A-J).

6. Procédé selon l'une quelconque des revendications précédentes, dans lequel le réseau comprend un câble (10) ayant des propriétés sensiblement constantes liées au moment de retard et à l'atténuation par longueur unitaire.

7. Procédé selon l'une quelconque des revendications précédentes, dans lequel le signal de détection comprend un signal ayant une fréquence entre 10 kHz et 1 Mhz, de préférence entre environ 95 kHz et 148,5 kHz.

8. Procédé selon l'une quelconque des revendications précédentes, dans lequel l'amplitude du signal de détection est accrue sensiblement linéairement en moment.

9. Procédé selon l'une quelconque des revendications 1 à 8, dans lequel l'amplitude du signal de détection est accrue pas-à-pas, de préférence avec un moment d'amplitude constante entre environ 1 ms et 5 s, de préférence entre environ 5 ms et 0,1 s.

10. Procédé selon la revendication 9, dans lequel le signal de détection est accru pas-à-pas entre environ 0,5 mV et 10 mV, de préférence entre 1 mV et 5 mV.

11. Réseau de dispositifs, comprenant un câble (10), et une pluralité de dispositifs adressables (A-I ; A-J) et une unité de commande (12) raccordés ainsi, les dispositifs étant dotés d'une horloge interne et étant synchronisés pour pouvoir mesurer un moment, et un dispositif sélectionné parmi le réseau de dispositifs (A-I ; A-J) étant capable de fournir un signal de détection sur le réseau, dans lequel le signal de détection a une amplitude qui augmente en fonction du moment et chaque dispositif restant est capable de déterminer un moment de détection, moment de détection auquel ledit dispositif restant est capable de détecter le signal de détection et l'unité de commande est capable de recueillir les moments de détection respectifs des dispositifs restants, et d'évaluer les moments de détection afin de déterminer la position relative des dispositifs (A-I ; A-J).

12. Réseau selon la revendication 11, dans lequel au moins deux dispositifs (AI ; A-J), et de préférence tous les dispositifs, sont capables de fournir et de détecter un signal de détection et de déterminer un moment écoulé.
